(19) Europäisches Patentamt
European Patent Office
Office européen des brevets

(11) **EP 2 631 984 A1**

(12) **EUROPEAN PATENT APPLICATION**
published in accordance with Art. 153(4) EPC

(43) Date of publication:
**28.08.2013 Bulletin 2013/35**

(51) Int Cl.:
*H01M 10/48* (2006.01)   *G01R 31/36* (2006.01)
*H01M 10/44* (2006.01)   *H02J 7/04* (2006.01)

(21) Application number: **11834326.8**

(22) Date of filing: **17.10.2011**

(86) International application number:
**PCT/JP2011/073862**

(87) International publication number:
**WO 2012/053487 (26.04.2012 Gazette 2012/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.10.2010   JP 2010233232**

(71) Applicant: **OHK Research Institute
Aichi 491-0111 (JP)**

(72) Inventor: **OKADA, Katsuo
Ichinomiya-shi
Aichi 491-0111 (JP)**

(74) Representative: **Stevens, Jason Paul
Dehns
St Bride's House
10 Salisbury Square
London
EC4Y 8JD (GB)**

(54) **BATTERY CHARGER AND BATTERY CHARGING METHOD**

(57)   [Problem to be Solved]
A battery charger and a battery charge method are provided. The battery charger and the battery charge method allow a battery to be charged in accordance with a charge algorithm optimum for the battery and based on a charge characteristic of the battery acquired at the time of daily charge of the battery.
[Solution]

A battery charger includes battery charge means for charging a battery connected thereto based on a predetermined charge algorithm and signal analysis means for analyzing the battery based on a charge signal sent from the battery charge means, and the battery charge means automatically switches the charge algorithm to another in accordance with the state of the battery analyzed by the signal analysis means and repeats the charge a predetermined number of times.

[Fig. 1]

EP 2 631 984 A1

**Description**

Technical Field

The present invention relates to a battery charger and a battery charge method for efficiently charging a battery, such as a lead battery, a nickel hydrogen secondary battery, and a lithium battery, to restore a charged state of the degraded battery.

Background Art

In a forklift, a golf cart, an off-the-road electric vehicle, and any other battery-powered electric vehicle, a battery having been used for years may abruptly fail and hence becomes unusable, resulting in a problem, for example, with transporting operation in some cases.
Further, in what is called an electric automobile (battery-powered electric automobile), which is strongly expected to relieve recent environmental issues, there is a concern about abrupt battery failure, as in the electric vehicles described above.
In particular, a battery-powered electric automobile travels not only in a particular area but also on a public road, unlike forklifts, golf carts and other similar electric vehicles. Such an abrupt battery failure could therefore lead, for example, to a traffic accident in some cases.
To detect such a failure in advance and take measures against it, a charged state of a battery needs to be readily restored in daily maintenance of the battery.
Causes of battery failures may include cell reversal due to over-discharge of the battery, sulfation due to deep discharge, and thermal runaway due to an increase in temperature of the battery during the charge thereof.
When such a battery failure occurs, an attempt is made to restore to a charged state of the battery by identifying a cause of the failure and then taking measures according to the behavior of the failure in related art. Further, since a cause of such a failure also depends on the type of battery, there has been no realistic remedy that restores a charged state of the battery in accordance with the type of the battery and the cause of the failure.
Further, a battery used in an electric vehicle, a battery-powered electric automobile, or any other similar vehicle is not a single battery formed of a single cell but is an assembled battery that is an assembly of a plurality of cells. An assembled battery becomes degraded when used and produces a difference in output performance among the cells (imbalance of cell voltage).
When the cell balance deteriorates and the output performance of part of the cells in an assembled battery decreases, the assembled battery as a whole cannot be charged or restored to a sufficient amount of electric capacity.
To restore the cell balance, it is conceivable to detect a cell having lowered output performance and charge the cell by a greater amount than the other cells.

Summary of Invention

Technical Problem

It is, however, typically difficult to provide means for restoring a charged state of a battery in accordance with the type of the battery and a cause of the failure, and it has not been realistic to inspect the battery and restore a charged state thereof in daily maintenance.
Further, to inspect the cell balance of an assembled battery, in general, the voltage and current values of the battery in use (during discharge) are measured and the discharge characteristic of the battery is continuously checked in related art. When an electric vehicle that accommodates the battery is used around the clock, however, the battery is exchanged in the course of operation and hence the battery cannot be inspected individually even when a battery inspection apparatus is loaded on the electric vehicle.
Further, in the case of a sealed battery, such as a lithium ion battery, which is frequently used in recent years, an increase in temperature of the battery due, for example, to overcharge leads to the risk of ignition, explosion, or any other accident in some cases. In view of the fact described above, most chargers terminate charge operation before a battery is fully charged in order to ensure safety.
As a result, when the cell balance of a sealed battery deteriorates even by a small degree, a charger senses a charge error. In this case, the battery cannot be normally charged, which leads to a situation where a vehicle that accommodates the battery abruptly comes to a halt or the battery needs to be exchanged, resulting in an increase in cost on the user.
In view of the current circumstances described above, an object of the present invention is to provide a battery charger and a battery charge method that allow a battery to be charged in accordance with a charge algorithm optimum for the battery based on a battery charge characteristic acquired at the time of charge of the battery so that a greater amount of electricity can be efficiently charged with a small amount of load on the battery and a charged state of the battery is restored.

Another object of the present invention is to provide a battery charger and a battery charge method that allow a battery to be fully charged without any risk, such as ignition and explosion, even when a lithium battery or any other sealed battery is charged, resulting in a decrease in cost burden on the user.

Solution to Problem

The present invention has been made to solve the problems in the related art described above and achieve the objects described above. A battery charger according to the present invention includes

battery charge means for charging a battery connected thereto based on a predetermined charge algorithm, and signal analysis means for analyzing the battery based on a charge signal sent from the battery charge means,

the battery charger characterized in that the battery charge means automatically switches the charge algorithm to another in accordance with the state of the battery analyzed by the signal analysis means and repeats the charge a predetermined number of times or until a predetermined full charge completion condition is satisfied.

The battery charger according to the present invention is further characterized in that the signal analysis means includes data storage means for storing data formed at least of the charge signal and an elapsed period sent from the battery charge means.

The battery charger according to the present invention is further characterized in that the signal analysis means includes abnormal event warning means for notifying an abnormal event.

The battery charger according to the present invention is further characterized in that the battery charger comprises battery information input means for recognizing individual battery information.

The battery charger according to the present invention is further characterized in that large constant current charge and small constant current charge are repeated as the charge algorithm.

The battery charger according to the present invention is further characterized in that pulse superimposed charge is performed as the charge algorithm.

The battery charger according to the present invention is further characterized in that the signal analysis means calculates a usage factor that is the ratio of a charged electricity level at which a battery voltage reaches an overvoltage monitoring start voltage to a rated capacity of the battery, that is,

```
usage factor = charged electricity level / rated capacity

and determines that the state of the battery is abnormal when the usage factor is smaller than a predetermined value.
```

The battery charger according to the present invention is further characterized in that the signal analysis means calculates an overvoltage rise factor that is the ratio of an overvoltage monitoring period from the time when a battery voltage reaches an overvoltage monitoring start voltage to the time when the battery voltage reaches an overvoltage monitoring termination voltage to a predetermined overvoltage monitoring reference period, that is,

```
overvoltage rise factor = overvoltage monitoring period / overvoltage monitoring reference period
```

and determines that the state of the battery is abnormal when the overvoltage rise factor is greater than a predetermined ratio.

The battery charger according to the present invention is further characterized in that the signal analysis means compares a rise period elapsed until a battery voltage reaches an overvoltage monitoring start voltage with an overvoltage monitoring period and determines that the state of the battery is abnormal when the overvoltage monitoring period is longer than the rise period.

The battery charger according to the present invention is further characterized in that the signal analysis means calculates a charged electricity level ratio of the level of electricity charged from the time when the charge is initiated to the time when the charge is completed to charged electricity level data stored in the data storage means, that is,

$$\text{charged electricity level ratio = charged electricity level / charged electricity level data}$$

and determines that the state of the battery is abnormal when the charged electricity level ratio is smaller than a predetermined value.

The battery charger according to the present invention is further characterized in that the signal analysis means compares a greatest battery voltage at the time of (n-1)-th charge (n≥2, n is a natural number) with a greatest battery voltage at the time of n-th charge stored in the data storage means, calculates

$$\Delta V2 = \text{(the greatest battery voltage at the time of (n-1)-th charge)} - \text{(the greatest battery voltage at the time of n-th charge)}$$

when the greatest battery voltage at the time of n-th charge is smaller than the greatest battery voltage at the time of (n-1)-th charge, and terminates the charge of the battery when the $\Delta V2$ is greater than a preset value.

The battery charger according to the present invention is further characterized in that the signal analysis means compares a greatest value of current flowing through the battery at the time of (n-1)-th charge (n>2, n is a natural number) with a greatest value of current flowing through the battery at the time of n-th charge stored in the data storage means, calculates $\Delta A$ = (the greatest value of current flowing through the battery at the time of (n-1)-th charge) - (the greatest value of current flowing through the battery at the time of n-th charge) when the greatest value of current flowing through the battery at the time of n-th charge is smaller than the greatest value of current flowing through the battery at the time of (n-1)-th charge, and determines that the state of the battery is abnormal when the $\Delta A$ is greater than a preset value.

The battery charger according to the present invention is further characterized in that the signal analysis means constantly measures internal resistance of the battery based on a battery voltage and current flowing through the battery and terminates the charge of the battery when a change $\Delta R$ in the internal resistance is greater than a preset value.

The battery charger according to the present invention is further characterized in that the battery charge means is battery charge and discharge means also including discharge means for discharging the battery.

A battery charge method according to the present invention is a battery charge method for charging a battery based on a predetermined charge algorithm, characterized in that the method includes determining the state of the battery based on a charge signal from the battery obtained during the charge of the battery; and automatically switching the charge algorithm to another in accordance with the state of the battery and repeating the charge a predetermined number of times.

Advantageous Effects of Invention

According to the present invention, since the battery charger automatically switches the charge algorithm to another in accordance with the state of the battery and charges the battery, the following advantages are provided: efficient charge; a small load on the battery; restoration of a non-degraded state of the battery; and a prolonged life of the battery.

Further, according to the present invention, when the state of a battery is detected to be abnormal or when a charge-related abnormal event or a discharge-related abnormal event occurs, the abnormal event warning means notifies that an abnormal event occurs, whereby an abnormal event of the battery can be detected at the time of daily charge of the battery.

Moreover, according to the present invention, since an abnormal state of a battery can be accurately known, charge and other operations that potentially have the risks of explosion of the battery and any other accident thereof can be safely performed.

Brief Description of Drawings

[Figure 1] Figure 1 is a block diagram showing a first configuration of a battery charger according to the present invention.

[Figure 2] Figure 2 shows graphs illustrating the relationship obtained when a battery is charged between a charge period and a battery voltage (charge characteristic), Figure 2(a) showing a graph illustrating an example of the charge characteristic obtained when a battery in a normal state is charged and Figure 2(b) showing a graph illustrating an example of the charge characteristic obtained when a battery in an abnormal state is charged.

[Figure 3] Figure 3 is a flowchart for describing the procedure of battery charge performed by the battery charger according to the present invention.

[Figure 4] Figure 4 shows graphs illustrating changes in cell voltages and a change in the average of the cell voltages that occur when the battery charger according to the present invention charges a battery.

[Figure 5] Figure 5 shows graphs illustrating changes in cell voltages and a change in the average of the cell voltages that occur when the battery charger according to the present invention charges a battery.

[Figure 6] Figure 6 shows a graph illustrating an example of the charge characteristic obtained when a battery in which a charge barrier, which is a kind of sulfation, is produced is charged.

[Figure 7] Figure 7 is a block diagram showing a second configuration of the battery charger according to the present invention.

Description of Embodiments

Embodiments (examples) of the present invention will be described below in more detail with reference to the drawings.

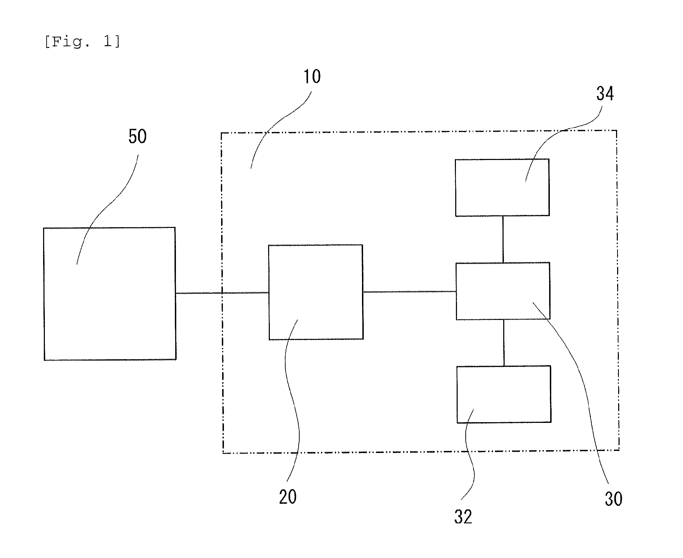

Figure 1 is a block diagram showing a first configuration of a battery charger according to the present invention.

The first configuration of the battery charger 10 according to the present invention includes battery charge means 20 for charging a battery 50 to which the battery charge means 20 is connected and signal analysis means 30 for analyzing the battery based on a signal sent from the battery charge means 20.

As the signal sent from the battery charge means 20, for example, the voltage across the battery or the current flowing through the battery at the time of charge may be directly used or may be converted by an AD conversion circuit (not shown) into a digital signal.

When the signal sent from the battery charge means 20 is, for example, the battery voltage or the current flowing through the battery, a splitter, such as shunt and a voltage divider, may be provided between the battery charge means 20 and the signal analysis means 30, and an electric signal flowing through the signal analysis means may be extracted through the splitter by a necessary and sufficient amount. In this case, to send the signal to the signal analysis means 30, the received signal may be converted into a digital signal by an AD conversion circuit (not shown).

When the signal sent from the battery charge means 20 is a digital signal, for example, a digital receiver that receives the signal as it is, a digital receiver with an error code correcting function, or any other suitable device may be used.

The battery charge means 20 is formed of a power supply section for supplying electric power and a charge control section for controlling charge operation. The power supply section can be a power supply used in a typical charger, for example, a switched-mode power supply or any other semiconductor power supply and a transformer.

The signal analysis means 30 is means for conducting data analysis based on digital data sent from the battery charge means 20 and can, for example, be a microcomputer, a custom IC, or an FPGA (field programmable gate array). The signal analysis means 30 may alternatively be a computer, such as a personal computer and a server, provided external to the battery charger 10.

In the present example, the battery charge means 20 is formed of the power supply section and the charge control section, but the signal analysis means 30 and the charge control section can alternatively be integrated with each other. That is, the charge control section, which controls charge operation, may be accommodated in the battery charge means 20 or in the signal analysis means 30.

The signal analysis means 30 further includes data storage means 32 for storing, for example, the following parameters sent from the battery charge means 20 as data: a charge signal, such as the battery voltage and the current flowing through the battery; and an elapsed charge period.

The data storage means 32 stores data, such as the charge signal obtained at the time of past charge operation and the elapsed charge period, and the signal analysis means 30 can diagnose the state of the battery 50 based on the data described above.

The signal analysis means 30 further includes abnormal event warning means 34 for notifying an abnormal event, for example when a charge-related abnormal event occurs. The abnormal event warning means 34 can, for example, be means for notifying an abnormal event in the form of a sound from a buzzer or any other device, means for notifying an abnormal event in the form of light from a lamp or any other device, or means that is a combination thereof. When a computer is used as the signal analysis means 30, a warning may be displayed on a display monitor connected to the computer.

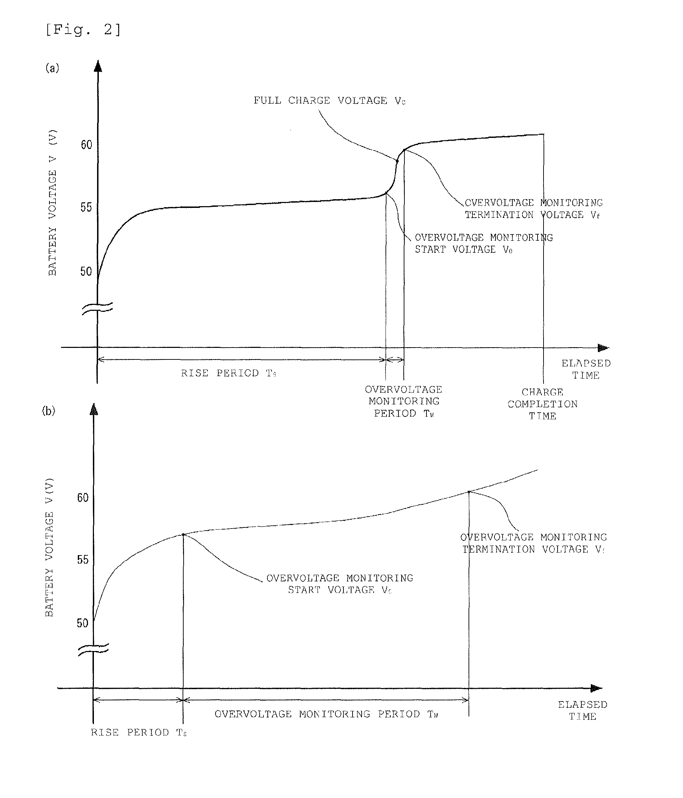

Figure 2 shows graphs illustrating the relationship obtained when a battery is charged between the charge period and the battery voltage (charge characteristic). Figure 2(a) shows a graph illustrating an example of the charge characteristic obtained when a battery in a normal state is charged, and Figure 2(b) shows a graph illustrating an example of the charge characteristic obtained when a battery in an abnormal state is charged.

In general, a timer is provided to prevent what is called overcharge that may occur when a battery is charged. The timer is configured to operate when the battery voltage V reaches an overvoltage monitoring termination voltage $V_f$ or operate when the battery voltage V reaches a full charge voltage $V_c$. After a period preset in accordance with the battery has elapsed, the timer terminates the charge operation.

In the thus configured battery charger 10 according to the present invention, the battery charge means 20 charges a battery, and at the same time, the signal analysis means 30 analyzes the charge signal (for example, the battery voltage or the current flowing through the battery) and automatically switches a charge algorithm to an appropriate one that allows the battery to be appropriately charged.

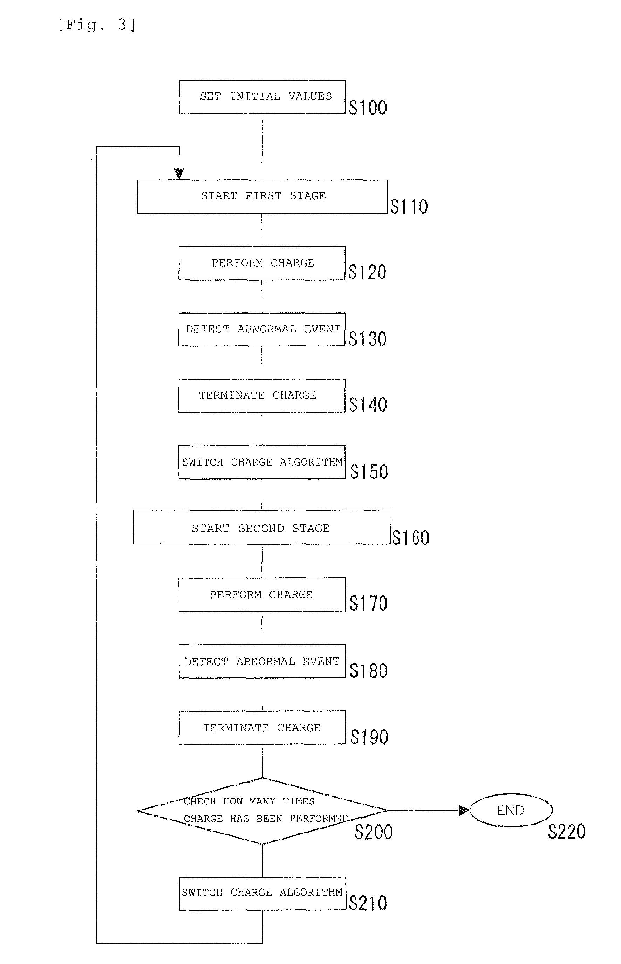

Specifically, a battery is charged in accordance with the flowchart shown in Figure 3.

First, initial values are set in the battery charger 10 based, for example, on the model number of a battery to be charged and the capacity of the battery. In the description, a rated capacity $C_{AH}$, an overvoltage monitoring start voltage $V_0$, an overvoltage monitoring termination voltage $V_f$, a charge repetition number, and other parameter of the battery are set as the initial values (S100).

To set, for example, the rated capacity $C_{AH}$ of the battery, numerical value input means (not shown) connected to the battery charger 10 may be provided for input operation, or a switch capable of switching the setting of the rated capacity $C_{AH}$ or any other parameter may be provided in the battery charger 10.

The overvoltage monitoring start voltage $V_0$ depends on the capacity, type, state, and other charge conditions of the battery. For example, in the case of a battery of a rated voltage of 48 V, the full charge voltage $V_c$ is about 58.5 V as shown in Figure 2(a), and the overvoltage monitoring start voltage $V_0$ can therefore be set at a value smaller than the full charge voltage $V_c$, for example, 56.5 V, which is smaller by 2 V.

Further, the overvoltage monitoring termination voltage $V_f$ needs to be set at a value greater than the overvoltage monitoring start voltage $V_0$. For example, in the case of the battery of a rated voltage of 48 V, and when the overvoltage monitoring start voltage $V_0$ is set at 56.6 V, the overvoltage monitoring termination voltage $V_f$ can be set at a value greater than the full charge voltage $V_c$, for example, at 59.5 V, which is greater by 1 V, as shown in Fig. 2(a).

First-stage charge is then performed in accordance with a charge algorithm based on the initial values (S110).

The charge algorithm used herein refers to a charge method, such as constant voltage charge, constant current charge, quick charge, and pulse charge. The battery charger 10 according to the present invention, which uses a combination of the charge methods described above, can preferably charge a battery in accordance with a charge algorithm according to the type and state of the battery.

In the first-stage charge (S120), for example, large constant current charge can be performed. Large constant current charge can shorten the period necessary for the charge. In large constant current charge, the current value is set, for example, at 10 A at the maximum or 5 A at the minimum, and when a current having a value that does not fall within the range flows, the abnormal event warning means 34 notifies the abnormal event and terminate the charge (S130).

Further, for example, when a predetermined period has elapsed since the first-stage charge started but the battery voltage has not reached the overvoltage monitoring start voltage $V_0$, the abnormal event warning means 34 can notify the abnormal event and terminate the charge (S130).

On the other hand, when the battery voltage has reached the overvoltage monitoring termination voltage $V_f$ (full charge voltage $V_c$ depending on the setting), the timer is activated and terminates the charge after a predetermined period elapses (S140).

Subsequently, before second-stage charge is initiated (S160), the battery charge algorithm is switched from the large constant current charge to, for example, small constant current charge, in which a relatively small charge current is used (S150). It is noted that a predetermined pause period is preferably provided at the timing S130 not only to switch the charge algorithm but also to lower the temperature of the battery that has risen in the charge process.

When small constant current charge is performed in the second-stage charge (S170), the charge can be performed, for example, by using a current value set at about 30% of the current value used in the large constant current charge. In this case as well, when a current having a value that does not fall within a predetermined range flows or when a predetermined period has elapsed but the overvoltage monitoring start voltage $V_0$ has not been reached, the abnormal event warning means 34 can notify the abnormal event and discontinue the charge (S180), as in the first-stage charge (S120).

In the second-stage charge as well, when the battery voltage has reached the overvoltage monitoring termination voltage $V_f$ (full charge voltage $V_c$ depending on the setting), the timer is activated and terminates the charge after a predetermined period elapses (S190).

After the second-stage charge is completed, it is checked how many times the combination of the first-stage charge and the second-stage charge has been performed (S200). When a predetermined number of charge operations have been performed, the charge is terminated (S220). The predetermined number can be set as appropriate based, for example, on the type and state of the battery.

In step S200, in which the number of charge operations is checked, other checking operations may also be performed on the battery 50, for example, the charged electricity level in the battery 50 is compared with the rated capacity of the battery 50 to see if the former is abnormally lower than the latter.

On the other hand, when the predetermined number of charge operations have not been performed, the signal analysis means analyzes the charge characteristic at the time of each charge operation having been performed and the current charge algorithm is switched to a preferable one (S210). A predetermined pause period is preferably provided also at the timing S190 not only to switch the charge algorithm but also to lower the temperature of the battery that has risen in the charge process.

As described above, battery failures, such as cell reversal, sulfation, and thermal sleep, and imbalance of the cell voltage can be eliminated by repeating the first-stage charge and the second-stage charge a predetermined number of times while the charge algorithm is switched. In the present invention, the first-stage charge and the second-stage charge form a single-loop charge, and the battery charger 10 according to the present invention charges a battery by repeating the loop charge.

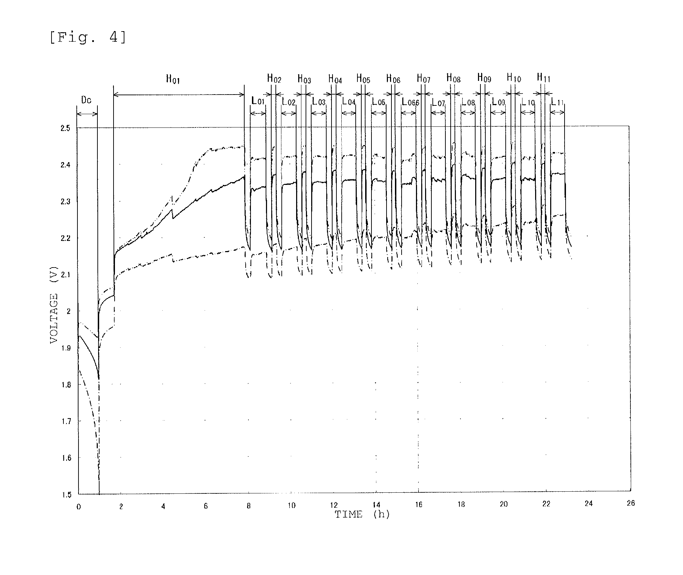

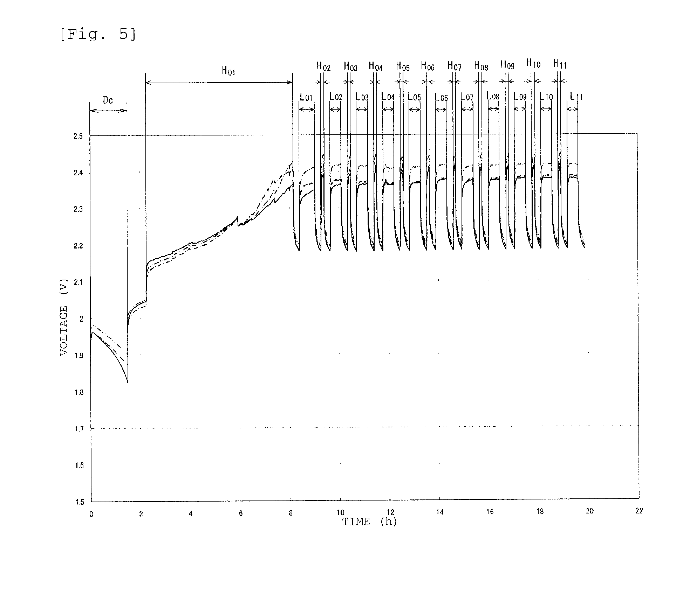

Figures 4 and 5 show graphs illustrating changes in cell voltages and a change in the average of the cell voltages that occur when the battery charger 10 according to the present invention charges a battery. Figure 5 shows changes in the cell voltages and a change in the average of the cell voltages that occur when the battery having been charged as shown in Figure 4 is used (discharged) and charged again. Figures 4 and 5 display only part of the cell voltages for ease of description.

In the present example, in which the battery charger 10 according to the present invention may be configured to acquire only the voltage across the overall battery (battery voltage) as the signal sent from the battery charge means 20, part of the cell voltages is also measured for convenience of description.

In Figures 4 and 5, the dashed line represents a change in the cell voltage across a cell A, the double dashed line represents a change in the cell voltage across a cell B, and the solid line represents a change in the average of the cell voltages.

Further, Hn denotes the charge period in the first stage, and Ln denotes the charge period in the second stage (n stands for the number of the charge operation in a single loop). Dc denotes a battery discharge period, and each period with no reference character represents a period in which the battery is not charged or discharged.

In the charge operations shown in Figures 4 and 5, pulse superimposed charge (charge method in which pulse voltage is applied during constant current charge) is performed as well as the large constant current charge and small constant current charge because the signal analysis means 30 switches the charge algorithm to a preferable one.

According to Figures 4 and 5, the difference in voltage between the cell A and the cell B is about 0.43 V at the time of discharge before they are charged in Figure 4 (that is, in Dc in Figure 4), but the difference in voltage between the cell A and the cell B decreases to about 0.03 V after they are charged in Figure 5 (that is, in $L_{11}$ in Figure 5).

As described above, repeating charge operation while switching the charge algorithm to a preferable one as described in the charge method according to the present invention can eliminate degradation of a battery, for example, cell reversal, sulfation, and thermal sleep, and restore the cell balance of the battery.

In steps S140 and S190, when a charge-related abnormal event is detected during the signal analysis, for example, when the battery voltage reaches an abnormal event threshold voltage $V_w$, or when the battery voltage does not reach the overvoltage monitoring start voltage $V_0$ even after a predetermined period has elapsed, the charge is terminated and the abnormal event warning means 34 notifies the charge-related abnormal event.

As the abnormal event threshold voltage $V_w$, a voltage $V_{w1}$ extremely larger than the rated voltage of the battery 50 and a voltage $V_{w2}$ extremely smaller than the rated voltage of the battery 50 can be set. For example, in the case of the battery of a rated voltage of 48 V, the abnormal event threshold voltage $V_{w1}$ can be 70 V, and the abnormal event threshold voltage $V_{w2}$ can be 25 V.

In this case, in either of the following cases: when the battery voltage becomes greater than the abnormal event threshold voltage $V_{w1}$; and when the battery voltage becomes smaller than the abnormal event threshold voltage $V_{w2}$, it is determined that a charge-related abnormal event has occurred, and not only can the charge of the battery 50 be terminated but also the abnormal event warning means 34 can notify the charge-related abnormal event.

Further, the signal analysis means 30 analyzes and evaluates the battery 50, for example, by using any of the following methods based on the data stored in the data storage means 32, such as the charge signal and the charge period in steps S140 and S190.

(1) Evaluation based on usage factor

The signal analysis means 30 uses the rated capacity $C_{AH}$ of the battery 50 set as the initial value and the charged electricity level C in the battery 50 at which the battery voltage reaches the overvoltage monitoring start voltage $V_0$ at the time of charge to calculate a usage factor $R_U$, which is the ratio of the charged electricity level C in the battery 50 to the rated capacity $C_{AH}$, that is,

$$\text{usage factor } R_U = \text{charged electricity level C / rated capacity } C_{AH}.$$

When the usage factor $R_U$ is smaller than a predetermined value, for example, 0.5 (50%), it is determined that the state of the battery 50 is abnormal, that is, the battery 50 has been degraded, and the charge algorithm can be switched to another that, for example, allows the battery 50 to be charged at a constant voltage for a long period. When it is determined that the state of the battery 50 is abnormal as described above, the abnormal event warning means 34 may notify that the state of the battery is abnormal. Battery degradation of this type often occurs particularly with a lead battery.

(2) Evaluation based on overvoltage rise factor

Based on the overvoltage monitoring start voltage $V_0$ and the overvoltage monitoring termination voltage $V_f$, which have been set as the initial values, and the charge characteristic of a normal battery, which has been stored in advance in the data storage means 32, the battery 50 can be evaluated by using an overvoltage monitoring period $T_W$ (overvoltage monitoring reference period $T_B$) from the time when the battery voltage reaches the overvoltage monitoring start voltage $V_0$ to the time when the battery voltage reaches the overvoltage monitoring termination voltage $V_f$.
The overvoltage monitoring reference period $T_B$ depends on the capacity, type, and state of the battery and is set, for example, at three hours or five hours in accordance with the characteristics of the battery 50.
During the charge of the battery 50, the overvoltage monitoring period $T_W$, which is the period from the time when the battery voltage reaches the overvoltage monitoring start voltage $V_0$ to the time when the battery voltage reaches the overvoltage monitoring termination voltage $V_f$, is measured after the charge of the battery 50 is initiated.
The signal analysis means 30 then calculates and determines an overvoltage rise factor $R_t$, which is the ratio of the overvoltage monitoring period $T_W$ to the overvoltage monitoring reference period $T_B$, that is,

$$\text{overvoltage rise factor } R_t = \text{overvoltage monitoring period } T_W / \text{overvoltage monitoring reference period } T_B.$$

When the overvoltage rise factor $R_t$ is greater than a predetermined value, for example, 2 (200%) (for example, when the overvoltage monitoring period $T_W$ is longer than six hours provided that the overvoltage monitoring reference period $T_B$ is set at three hours), it is determined that the state of the battery 50 is abnormal, that is, the battery 50 has been degraded. When it is determined that the state of the battery 50 is abnormal as described above, the abnormal event warning means 34 may notify that the state of the battery is abnormal. Battery degradation of this type often occurs particularly with a lithium battery.

(3) Evaluation based on overvoltage monitoring period

Based on the overvoltage monitoring start voltage $V_0$, which has been set as the initial value, and the charge characteristic of a normal battery, which has been stored in advance in the data storage means 32, the battery 50 can be evaluated by using the overvoltage monitoring period $T_W$ necessary for the battery voltage to reach the overvoltage

monitoring start voltage $V_0$.

During the charge of the battery 50, a rise period $T_S$, which is the period from the time when the charge starts to the time when the battery voltage reaches the overvoltage monitoring start voltage $V_0$, is measured.

The measured rise period $T_s$ is then compared with the overvoltage monitoring period $T_W$. When the overvoltage monitoring period $T_W$ is longer than the rise period $T_s$, it is determined that the state of the battery 50 is abnormal, that is, the battery 50 has been degraded. When it is determined that the state of the battery 50 is abnormal as described above, the abnormal event warning means 34 may notify that the state of the battery is abnormal. Battery degradation of this type often occurs particularly with a lead battery.

(4) Evaluation based on charged electricity level ratio

Whenever the battery 50 is charged, the level of electricity charged from the time when the charge is initiated to the time when the charge is completed is stored in the data storage means 32. The signal analysis means 30 then calculates and determines the charged electricity level ratio of the level of electricity charged from the time when the charge is initiated to the time when the charge is completed to the data stored in the data storage means 32 on the level of electricity charged in the charge operation performed a predetermined number before the current charge operation, that is,

```
charged electricity level ratio = charged electricity level / data on charged electricity level.
```

When the charged electricity level ratio is greater than a predetermined value, for example, a value 1.5 to 2 greater than a predetermined reference value of the charged electricity level ratio, it is determined that the state of the battery 50 is abnormal, that is, the battery 50 has been degraded. When it is determined that the state of the battery 50 is abnormal as described above, the abnormal event warning means 34 may notify that the state of the battery is abnormal.

(5) Evaluation based on $\Delta V1$

When the battery voltage decreases during the charge in a certain stage as indicated, for example, by $L_{05}$ in Figure 4, the decrease is detected as $\Delta V1$. When $\Delta V1$ is greater than a preset value, the abnormal event warning means 34 can notify the abnormal event and terminate the charge.

The preset value of $\Delta V1$ can be set as appropriate in accordance with the type and rated voltage of the battery. For example, in the case of the battery of a rated voltage of 48 V, the preset value of $\Delta V1$ can be set at 0.1 V with respect to the average of the cell voltages (battery voltage of about 2 to 2.5 V). The situation in which $\Delta V1$ is detected as described above often occurs particularly with a nickel hydrogen secondary battery.

(6) Evaluation based on $\Delta V1'$

In contrast to $\Delta V1$, when the battery voltage abruptly increases in a period close to the end of the charge in a certain stage, that is, in a period where the battery voltage should be substantially constant, the increase is detected as $\Delta V1'$. When $\Delta V1'$ is greater than a preset value, the abnormal event warning means 34 can notify the abnormal event and terminate the charge.

The preset value of $\Delta V1'$ can be set as appropriate in accordance with the type and rated voltage of the battery. For example, in the case of the battery of a rated voltage of 48 V, the preset value of $\Delta V1'$ can be set at 0.12 V with respect to the average of the cell voltages (battery voltage of about 3 V). The situation in which $\Delta V1'$ is detected as described above often occurs particularly with a lithium battery.

(7) Evaluation based on $\Delta V2$

When the greatest battery voltage at the time of n-th charge is smaller than the greatest battery voltage at the time of (n-1)-th charge as indicated, for example, by $H_{08}$ and $H_{09}$ in Figure 4, the decrease is detected as $\Delta V2$. When $\Delta V2$ is greater than a preset value, it is determined that a full charge condition is satisfied and the charge can be terminated.

When $\Delta V2$ has a large value as described above, it can be determined that the battery cannot be charged any more, that is, a charge limit is reached. In this case, the charge of the battery can be normally terminated.

The preset value of $\Delta V2$ can be set as appropriate in accordance with the type and rated voltage of the battery. For example, in the case of the battery of a rated voltage of 48 V, the preset value of $\Delta V2$ can be set at 0.1 V with respect to the average of the cell voltages (battery voltage of about 2 to 2.5 V). The situation in which $\Delta V2$ is detected as described above may occur with a lead battery, a nickel hydrogen secondary battery, and a lithium battery.

(8) Evaluation based on $\Delta V3$

When the greatest battery voltage at the time of n-th charge is smaller than the greatest battery voltage at the time of m-th charge (m<n), the decrease is detected as $\Delta V3$, as in the case of $\Delta V2$. When $\Delta V3$ is greater than a preset value, it is determined that a full charge condition is satisfied and the charge can be terminated.

When $\Delta V3$ has a large value as described above, it can be determined that the battery cannot be charged any more, that is, a charge limit is reached. In this case, the charge of the battery can be normally terminated.

The preset value of $\Delta V3$ can be set as appropriate in accordance with the type and rated voltage of the battery. For example, in the case of the battery of a rated voltage of 48 V, the preset value of $\Delta V3$ can be set at 0.1 V with respect to the average of the cell voltages (battery voltage of about 2 to 2.5 V). The situation in which $\Delta V3$ is detected as described above may occur with a lead battery, a nickel hydrogen secondary battery, and a lithium battery.

The battery 50 can also be evaluated by using a combination of the evaluation methods shown in (1) to (8), or in addition to the evaluation methods shown in (1) to (8), for example, an evaluation method using $\Delta A$ and an evaluation method using $\Delta R$ can be used, as described below.

(9) Evaluation based on $\Delta A$

The present example is so configured that only the battery voltage is acquired, but the value of the current flowing through the battery can be acquired as the signal sent from the battery charge means 20. During constant voltage charge, the value of the current flowing through the battery abruptly increases in some cases, and the increase is detected as $\Delta A$. When $\Delta A$ is greater than a preset value, the abnormal event warning means 34 can notify the abnormal event occurs and terminate the charge.

The preset value of $\Delta A$ can be set as appropriate in accordance with the type of the battery and the current value in constant current charge. For example, in the case of a battery of a rated capacity of 400 AH, the preset value of $\Delta A$ can be set at a value ranging from about 5 to 10 A. The situation in which $\Delta A$ is detected as described above often occurs particularly with a nickel hydrogen secondary battery.

(10) Evaluation based on $\Delta R$

The battery voltage and the value of the current flowing through the battery may be acquired as the signal sent from the battery charge means 20. In this case, the internal resistance of the battery 50 can be constantly measured.

The internal resistance of the battery 50 changes with the degree of restoration of the battery. When a battery is degraded, the internal resistance has a large value, whereas when a charged state of the battery is restored, the internal resistance has a small value.

In view of the fact described above, when $\Delta R$, which represents the change in internal resistance of the battery 50, is continuously measured during charge operation and the measured $\Delta R$ is greater than a preset value (when internal resistance has a satisfactory value), it is determined that a full charge condition is satisfied and the charge can be terminated.

In the present example, in which a battery is charged by repeating the large constant current charge and small constant current charge, the charge algorithm can be changed in accordance with the state of the battery and other factors. For example, a battery may be charged by using a combination of large constant current charge, intermediate constant current charge, and small constant current charge. When an evaluation result shows that a battery in question has not been degraded very much, the magnitude of the charge current may be increased and the charge period may be shortened. Conversely, when an evaluation result shows that a battery in question has been greatly degraded, the magnitude of the charge current may be lowered and the charge period may be increased, and even pulse charge may be performed, whereby a greater amount of electricity can be charged in the degraded battery.

Specifically, a charged state of a degraded battery can be restored by charging the battery as described below by way of example.

For example, when the evaluation based on the overvoltage rise factor is made as described in (2) and the resultant overvoltage rise factor $R_t$ is greater than a predetermined value, it can be determined that overvoltage degradation has occurred in the battery.

Further, when a battery has been continuously charged for a predetermined period but the battery voltage does not reach the overvoltage monitoring termination voltage $V_f$, it can be determined that overvoltage degradation has occurred in the battery.

In this case, the battery that is difficult to be charged due to the overvoltage degradation can be charged by lowering the overvoltage monitoring termination voltage $V_f$, for example, by 1 V before the charge.

Further, for example, when a cell short circuit occurs in a battery, the battery that is difficult to be charged due to the cell short circuit can be charged in repeated large constant current charge and small constant current charge, for example, by adjusting the difference between the voltage produced when a large constant current flows and the voltage produced when a small constant current flows.

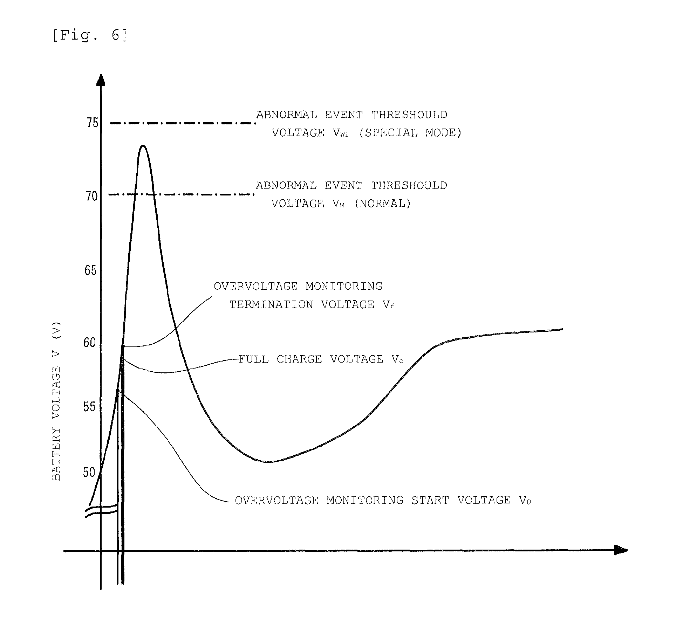

Further, when the charge voltage at the time of charge has, for example, the waveform shown in Figure 6, it is likely that a charge barrier, which is a kind of sulfation, has been produced. In this case, the charge barrier is eliminated by performing charge operation based on an abnormal event threshold voltage $V_{w1}$ in a special mode, which is the abnormal event threshold voltage $V_w$ set at a value greater than the overvoltage monitoring termination voltage $V_f$ and further increased, for example, by 5 V, and keeping the charge even when a measured value of the charge current becomes 0 A.

That is, the barrier can be eliminated with time by setting the abnormal event threshold voltage $V_w$ at a large value so that the charge is continuously performed at a voltage greater than a typical value, whereby the battery can be so restored to a state in which the battery are normally charged and discharged.

The battery charger 10 is preferably provided with a switch (not shown) that allows the charge operation to be switched as appropriate as described above to restore a charged state of the battery.

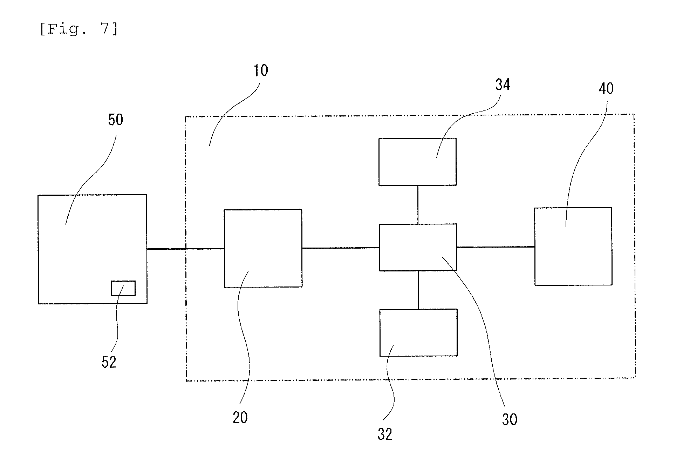

Figure 7 is a block diagram showing a second configuration of the battery charger according to the present invention.

The battery charger 10 shown in Figure 7 has a configuration basically the same as the configuration of the battery charger 10 shown in Figure 1. The same components as those in Figure 1 have the same reference characters, and detailed description thereof will be omitted.

A single battery charger, such as the battery charger 10 according to the present invention, typically charges a plurality of batteries in some cases. In this case, the battery charger can be provided with battery information input means 40 for recognizing information on the individual batteries.

The battery information input means 40 can, for example, be a barcode scanner or an ID tag reader. The ID tag reader used herein is an apparatus capable of reading information from a tag in which ID information is embedded, such as an RFID tag and an optical ID tag.

To use a battery charger including the thus configured battery information input means 40, each battery has an individual battery identifier 52, such as a barcode, an RF tag, an IC tag, or any other ID tag, corresponding to the battery information input means.

Further, providing a key input device, such as a keyboard, as the battery information input means 40 allows an operator to input an identification number given to each battery through the key input device.

The individual battery identifier 52 contains at least information by which the battery can be identified, for example, a battery identification number.

As described above, providing the individual battery identifier 52 specific to each battery allows the battery information input means 40 to acquire information on the battery in question when the battery is charged.

As a result, for example, when an evaluation using data on past charge operation stored in the data storage means is made, for example, when the evaluation based on the charged electricity level ratio described above is made, data stored in relation to individual battery information can be used, whereby a single battery charger can effectively charge a plurality of batteries.

Further, storing the rated capacity $C_{AH}$, the overvoltage monitoring start voltage $V_0$, and other parameters of each battery in the data storage means 32 in relation to individual battery information eliminates the need to set the initial values of the battery in the battery charger whenever the battery is charged, whereby a user can effectively charge the battery only by using the battery information input means 40 to read the individual battery identifier 52.

Preferable examples of the present invention have been described above, but the present invention is not limited thereto. For example, in the present examples, the state of a battery is analyzed by analyzing only the signal sent from the battery charge means 20 at the time of charge of the battery, but the state of the battery can be more precisely analyzed by providing the battery charge means 20 with discharge means and analyzing also a signal sent from the battery charge and discharge means 20 at the time of discharge of the battery.

Reference Signs List

    10: Battery charger

20: Battery charge means
30: Signal analysis means
32: Data storage means
34: Abnormal event warning means
40: Battery information input means
50: Battery
52: Individual battery identifier

**Claims**

1. A battery charger comprising:

   battery charge means for charging a battery connected thereto based on a predetermined charge algorithm; and signal analysis means for analyzing the battery based on a charge signal sent from the battery charge means, the battery charger **characterized in that** the battery charge means automatically switches the charge algorithm to another in accordance with the state of the battery analyzed by the signal analysis means and repeats the charge a predetermined number of times or until a predetermined full charge completion condition is satisfied.

2. The battery charger according to claim 1,
   **characterized in that** the signal analysis means includes data storage means for storing data formed at least of the charge signal and an elapsed period sent from the battery charge means.

3. The battery charger according to claim 1 or 2,
   **characterized in that** the signal analysis means includes abnormal event warning means for notifying an abnormal event.

4. The battery charger according to any of claims 1 to 3,
   **characterized in that** the battery charger comprises battery information input means for recognizing individual battery information.

5. The battery charger according to any of claims 1 to 4,
   **characterized in that** large constant current charge and small constant current charge are repeated as the charge algorithm.

6. The battery charger according to claim 5,
   **characterized in that** pulse superimposed charge is performed as the charge algorithm.

7. The battery charger according to any of claims 1 to 6,
   **characterized in that** the signal analysis means calculates a usage factor that is the ratio of a charged electricity level at which a battery voltage reaches an overvoltage monitoring start voltage to a rated capacity of the battery, that is,

$$\text{usage factor} = \text{charged electricity level / rated capacity}$$

   and determines that the state of the battery is abnormal when the usage factor is smaller than a predetermined value.

8. The battery charger according to any of claims 1 to 7,
   **characterized in that** the signal analysis means calculates an overvoltage rise factor that is the ratio of an overvoltage monitoring period from the time when a battery voltage reaches an overvoltage monitoring start voltage to the time when the battery voltage reaches an overvoltage monitoring termination voltage to a predetermined rise reference period, that is,

```
overvoltage rise factor = overvoltage monitoring period / rise reference period
```

and determines that the state of the battery is abnormal when the overvoltage rise factor is greater than a predetermined ratio.

**9.** The battery charger according to any of claims 1 to 8,
**characterized in that** the signal analysis means compares a rise period elapsed until a battery voltage reaches an overvoltage monitoring start voltage with a reference period and determines that the state of the battery is abnormal when the rise period is longer than the reference period.

**10.** The battery charger according to any of claims 2 to 9,
**characterized in that** the signal analysis means compares a greatest battery voltage at the time of (n-1)-th charge (n>2, n is a natural number) with a greatest battery voltage at the time of n-th charge stored in the data storage means, calculates

```
ΔV2 = (the greatest battery voltage at the time of (n-1)-th charge) - (the greatest battery voltage at the time of n-th charge)
```

when the greatest battery voltage at the time of n-th charge is smaller than the greatest battery voltage at the time of (n-1)-th charge, and terminates the charge of the battery when the ΔV2 is greater than a preset value.

**11.** The battery charger according to any of claims 1 to 10,
**characterized in that** the signal analysis means compares a greatest value of current flowing through the battery at the time of (n-1)-th charge (n>2, n is a natural number) with a greatest value of current flowing through the battery at the time of n-th charge stored in the data storage means, calculates

```
ΔA = (the greatest value of current flowing through the battery at the time of (n-1)-th charge) - (the greatest value of current flowing through the battery at the time of n-th charge)
```

when the greatest value of current flowing through the battery at the time of n-th charge is smaller than the greatest value of current flowing through the battery at the time of (n-1)-th charge, and determines that the state of the battery is abnormal when the ΔA is greater than a preset value.

**12.** The battery charger according to any of claims 2 to 11,
**characterized in that** the signal analysis means constantly measures internal resistance of the battery based on a battery voltage and current flowing through the battery and terminates the charge of the battery when a change ΔR in the internal resistance is greater than a preset value.

13. The battery charger according to any of claims 1 to 12,
**characterized in that** the battery charge means is battery charge and discharge means also including discharge means for discharging the battery.

14. A battery charge method for charging a battery based on a predetermined charge algorithm, **characterized in that** the method comprises:

determining the state of the battery based on a charge signal from the battery obtained during the charge of the battery; and
automatically switching the charge algorithm to another in accordance with the state of the battery and repeating the charge a predetermined number of times.

[Fig. 1]

[Fig. 2]

(a)

FULL CHARGE VOLTAGE $V_c$

BATTERY VOLTAGE V (V)

60

55

50

OVERVOLTAGE MONITORING
TERMINATION VOLTAGE $V_f$

OVERVOLTAGE MONITORING
START VOLTAGE $V_0$

RISE PERIOD $T_s$

OVERVOLTAGE
MONITORING
PERIOD $T_w$

ELAPSED
TIME

CHARGE
COMPLETION
TIME

(b)

BATTERY VOLTAGE V (V)

60

55

50

OVERVOLTAGE MONITORING
TERMINATION VOLTAGE $V_f$

OVERVOLTAGE MONITORING
START VOLTAGE $V_0$

RISE PERIOD $T_s$

OVERVOLTAGE MONITORING PERIOD $T_w$

ELAPSED
TIME

[Fig. 3]

```
        ┌──────────────────────┐
        │  SET INITIAL VALUES  │ S100
        └──────────┬───────────┘
                   │
        ┌──────────▼───────────┐
        │   START FIRST STAGE  │ S110
        └──────────┬───────────┘
                   │
        ┌──────────▼───────────┐
        │    PERFORM CHARGE    │ S120
        └──────────┬───────────┘
                   │
        ┌──────────▼───────────┐
        │ DETECT ABNORMAL EVENT│ S130
        └──────────┬───────────┘
                   │
        ┌──────────▼───────────┐
        │   TERMINATE CHARGE   │ S140
        └──────────┬───────────┘
                   │
        ┌──────────▼───────────┐
        │SWITCH CHARGE ALGORITHM│ S150
        └──────────┬───────────┘
                   │
        ┌──────────▼───────────┐
        │  START SECOND STAGE  │ S160
        └──────────┬───────────┘
                   │
        ┌──────────▼───────────┐
        │    PERFORM CHARGE    │ S170
        └──────────┬───────────┘
                   │
        ┌──────────▼───────────┐
        │ DETECT ABNORMAL EVENT│ S180
        └──────────┬───────────┘
                   │
        ┌──────────▼───────────┐
        │   TERMINATE CHARGE   │ S190
        └──────────┬───────────┘
                   │
              ◇─────────────◇
             ╱ CHECH HOW MANY ╲
            ╱  TIMES CHARGE    ╲────────▶ ( END )  S220
            ╲ HAS BEEN PERFORMED╱  S200
             ╲─────────────────╱
                   │
        ┌──────────▼───────────┐
        │SWITCH CHARGE ALGORITHM│ S210
        └──────────────────────┘
```

[Fig. 4]

[Fig. 5]

[Fig. 6]

[Fig. 7]

| | INTERNATIONAL SEARCH REPORT | International application No. |
|---|---|---|
| | | PCT/JP2011/073862 |

**A. CLASSIFICATION OF SUBJECT MATTER**
*H01M10/48*(2006.01)i, *G01R31/36*(2006.01)i, *H01M10/44*(2006.01)i, *H02J7/04*(2006.01)i

According to International Patent Classification (IPC) or to both national classification and IPC

**B. FIELDS SEARCHED**

Minimum documentation searched (classification system followed by classification symbols)
H01M10/48, G01R31/36, H01M10/44, H02J7/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2009-236629 A (Yugen Kaisha OHK Kenkyusho),<br>15 October 2009 (15.10.2009),<br>paragraphs [0029] to [0100]; fig. 1, 5, 9<br>(Family: none) | 1-11,13,14<br>12 |
| A | JP 2010-504729 A (Powergenix Systems, Inc.),<br>12 February 2010 (12.02.2010),<br>entire text; all drawings<br>& EP 2064795 A      & WO 2008/036948 A2<br>& CA 2664022 A      & KR 10-2009-0065539 A<br>& CN 101529692 A | 1-14 |
| A | JP 2009-284571 A (Yugen Kaisha OHK Kenkyusho),<br>03 December 2009 (03.12.2009),<br>entire text; all drawings<br>(Family: none) | 1-14 |

☐ Further documents are listed in the continuation of Box C.    ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 10 January, 2012 (10.01.12) | 17 January, 2012 (17.01.12) |

| Name and mailing address of the ISA/ | Authorized officer |
|---|---|
| Japanese Patent Office | |
| Facsimile No. | Telephone No. |

Form PCT/ISA/210 (second sheet) (July 2009)